# EUROPEAN PATENT APPLICATION

(11) **EP 1 578 021 A1**
(43) Date of publication of application: **21.09.2005**
(21) Application number: 05102138.4
(22) Date of filing: 18.03.2005
(51) Int. Cl.: H03M 13/25, H04L 25/49

(54) **Coded modulation device and method**

(30) Priority: 18.03.2004 JP 2004078971
(71) Applicant: NEC CORPORATION, Tokyo (JP)
(72) Inventor: Mitsutani, Naoki, Tokyo (JP)
(74) Representative: Betten & Resch

(57) **Abstract**

The present invention realizes a high coding gain employing a non-linear coding and a non-linear mapping. A converter converts one row of data that is inputted from a terminal into plural rows of data. Thenon-linear encoders non-linearly encode lower level two rows of data in plural rows of converted data, and outputs them as data of level 1 and level 2 to a non-linear mapping circuit. The non-linear mapping circuit maps the data non-linearly encoded by the non-linear encoders and the uncoded data so that each codeword distance may be optimal. A modulator modulates a carrier wave with two-dimensional data that are mapped by the non-linear mapping circuit.

## Description

### BACKGROUND OF THE INVENTION

### Field of the Invention

The present invention relates to a coded modulation device and method, and more particularly to a coded modulation device and method for increasing the coding gain by using the non-linear code and non-linear mapping.

### Description of the Prior Art

In recent years, in a digital microwave communications system, a coded modulation system with higher error-correcting ability is employed to achieve the higher transmission quality.

The coded modulation system integrates the mapping with signal point set partitioning and an error correction coding technique, and has an excellent error-correcting ability.

As the coding scheme, a Trelis Coded Modulation (TCM) system and a Multi Level Coded Modulation (MLCM) system are generally known.

In the Trelis coded modulation (TCM) system, a two-dimensional vector representation corresponds one-to-one to each signal point of a two-dimensional or multi-dimensional modulation system having 2^{m} signal points in two dimensions. And the Trelis coded modulation system gives one two-dimensional or multi-dimensional signal point by a combination of one convolutional encoder output and uncoded bits.

On the other hand, the multi level coded modulation system uses a plurality of block encoders having a different error correcting ability, each encoder coding data at each level corresponding to each component (bit position) of a two-dimensional vector, independently of each other. Each of codes for use with the multi level coded modulation method are referred to as a component code. For each component code, the required error correcting ability is decided based on the minimal signal point-to-point distance at the level to which it is applied (e.g., refer to Patent Document 1).

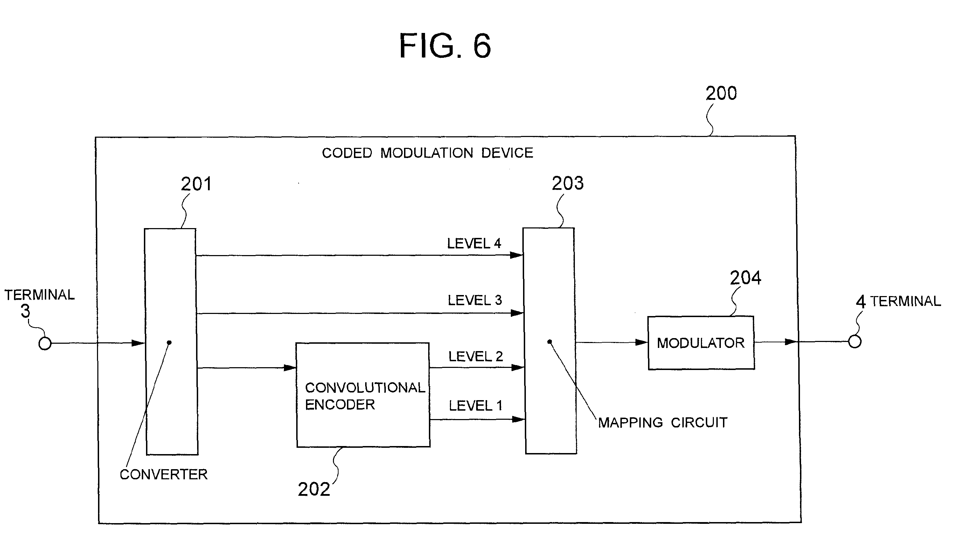

FIG. 6 is a block diagram showing a conventional coded modulation device.

Particularly, a case of the Trelis coded modulation (TCM) system is shown.

Referring to FIG. 6, in a coded modulation device 200, one row of data inputted from a terminal 3 is converted into three rows by a converter 201. Among them, one row is encoded into two rows of signals by a convolutional encoder 202. The two rows of signals are supplied as signals of level 1 and level 2 to a mapping circuit 203. Also, other two rows of signals outputted from the converter 201 are supplied as uncoded signals of levels to the mapping circuit 203.

In the mapping circuit 203, the coordinates of a signal point corresponding to a signal input are outputted with a signal point arrangement based on a signal point set partitioning. This signal point coordinate output is inputted into a modulator 204 for 16 QAM modulation, and outputted from a terminal 4.

This TCM uses a single convolutional code, with a very small degree of freedom in setting a coding ratio. Also, since the convolutional code is a kind of linear code, there is some limit on the coding gain of TCM.

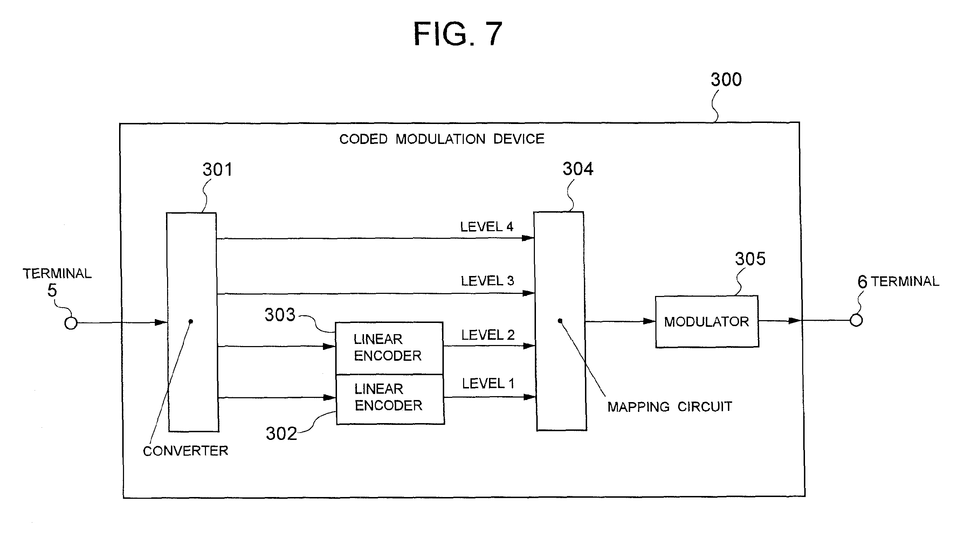

FIG. 7 is a block diagram showing another conventional coded modulation device.

Particularly, a case of the multi-level coded modulation (MLCM) method is shown.

Referring to FIG. 7, in a coded modulation device 300, one row of data inputted from a terminal 5 is converted into four rows by a converter 301. Among them, two rows of data at the lower level are encoded by a linear encoder 302 and a liner encoder 303, and outputted as signals of level 1 and level 2. The linearly coded signals of level 1 and level 2 and the uncoded signals of level 3 and level 4 are supplied to a mapping circuit 304.

In the mapping circuit 304, the coordinates of a signal point corresponding to a signal input are outputted with a signal point arrangement based on a signal point set partitioning. This signal point coordinate output is inputted into a modulator 305 for 16 QAM modulation, and outputted from a terminal 6.

This MLCM employs a different code at each level in the signal point set partitioning, with a larger degree of freedom in setting the coding ratio than the TCM. However, since the code for use at each level is a linear code, such as Hamming code, BCH (Bose Chaudhuri Hocquenghem) code, or RS (Reed Solomon) code, there is some limit on the coding gain.

Also, employing the convolutional code, the error correcting ability of coded modulation may be enhanced under the burst error environment such as fading (e. g. , refer to Patent Document 2).
[Patent Document 1] Japanese Patent Publication No. 2-291743 (pages 2 to 4)
[Patent Document 2] Japanese Patent Publication No. 9-93295 (pages 2 and 3, FIG. 2)

For above-mentioned conventional coded modulation device and method, the Trelis coded modulation (TCM) and the multi-level coded modulation (MLCM) are provided.

Since this TCM employs a single convolutional code, the degree of freedom in setting the coding ratio is very small. Since the convolutional code is a kind of linear code, there is some limit on the coding gain of the TCM.

Also, since the MLCM employs a different code at each level in the signal point set partitioning, there is a larger degree of freedom in setting the coding ratio than the TCM. However, since the code for use at each level is a linear code such as Hamming code, BCH code or RS code, there is some limit on the coding gain.

### BRIEF SUMMARY OF THE INVENTION

It is an object of the present invention to provide a coded modulation device and method for converting the transmission data into plural rows, making the non-linear coding for the lower level data, and making the non-linear mapping of mapping the coded data to signal points having a codeword distance of unequal interval on a two-dimensional plane to achieve a higher coding gain.

The present invention provides a first coded modulation method for converting the transmission data into plural rows, non-linearly encoding a part in plural rows of converted data, and non-linearly mapping the non-linearly coded data to signal points having a codeword distance of unequal interval on a two-dimensional plane.

The invention provides a second coded modulation method for converting the transmission data into plural rows, and non-linearly mapping the lower level data being non-linearly coded in plural rows of converted data, and the upper level data in the plural rows of converted data to signal points having a codeword distance of unequal interval on a two-dimensional plane.

The invention provides a first coded modulation device comprising a data converter for converting the transmission data into plural rows, a non-linear encoder for non-linearly encoding the lower level data in plural rows of data that are outputted from the data converter, a non-linear mapping part for non-linearly mapping the non-linearly coded data to signal points having a codeword distance of unequal interval on a two-dimensional plane, and a modulator for modulating a carrier wave with data mapped by the non-linear mapping part.

The invention provides a second coded modulation device comprising a data converter for converting the transmission data into plural rows, a non-linear encoder for non-linearly encoding the lower level data in plural rows of data that are outputted from the data converter, a non-linear mapping part for non-linearly mapping the non-linearly coded data and the upper level data in the plural rows of converted data to signal points having a codeword distance of unequal interval on a two-dimensional plane, and a modulator for modulating a carrier wave with data mapped by the non-linear mapping part.

The invention provides a third coded modulation device comprising a converter, a first non-linear encoder and a second non-linear encoder,a non-linear mapping circuit,and a modulator, wherein the converter converts one row of data that is inputted from a first terminal into plural rows of data, the first and second non-linear encoders non-linearly encode lower level two rows of data in plural rows of data converted by the converter, and output them as data of level 1 and level 2 to the non-linear mapping circuit, the non-linear mapping circuit non-linearly maps the data of level 1 and level 2 that are non-linearly encoded by the first and second non-linear encoders and the uncoded data of level 3 and level 4 to signal points having a codeword distance of unequal interval on a two-dimensional plane, and the modulator modulates a carrier wave with two-dimensional data that are non-linearly mapped by the non-linear mapping circuit.

The invention provides a third coded modulation method comprising converting one row of data that is inputted from a first terminal into plural rows of data, non-linearly encoding lower level two rows of data in plural rows of converted data, and outputting them as data of level 1 and level 2, non-linearly mapping the data of level 1 and level 2 that are non-linearly encoded and the uncoded data of level 3 and level 4 to signal points having a codeword distance of unequal interval on a two-dimensional plane, and modulating a carrier wave with two-dimensional data that are non-linearly mapped by the non-linear mapping.

The invention provides the fourth coding modulation method,
wherein the non-linear coding is generated by a non-linear equation of simultaneous multi-dimensional polynomials.

The invention provides the fifth coding modulation method,
wherein the non-linear coding is generated by a non-linear connection of generator polynomials.

The invention provides the fourth coding modulation device,
wherein the non-linear encoder is composed of a generation circuit that is generated by a non-linear equation of simultaneous multi-dimensional polynomials.

The invention provides the fifth coding modulation device,
wherein the non-linear encoder is generated by a non-linear connecting circuit of generator polynomials.

The coded modulation device and method of the invention makes the coded modulation employing the non-linear coding and non-linear mapping. Therefore, there is the effect that the higher coding gain is achieved because the codeword distance is secured larger than the coded modulation system employing the linear code.

### BRIEF DESCRIPTION OF THE DRAWINGS

FIG. 1 is a block diagram showing one embodiment of a coded modulation device and method according to one embodiment of the present invention;
FIG. 2 is a view showing an example of mapping of the invention;
FIG. 3 is a view showing one example of a signal point set partitioning operation as shown in FIG. 2;
FIG. 4 is a view showing another example of mapping of the invention;
FIG. 5 is a view showing one example of a signal point set partitioning operation as shown in FIG. 4;
FIG. 6 is a block diagram showing a conventional coded modulation device; and
FIG. 7 is a block diagram showing another conventional coded modulation device.

### DETAILED DESCRIPTION OF THE PREFERRED EMBODIMENTS

The preferred embodiments of the present invention will be described below with reference to the accompanying drawings.

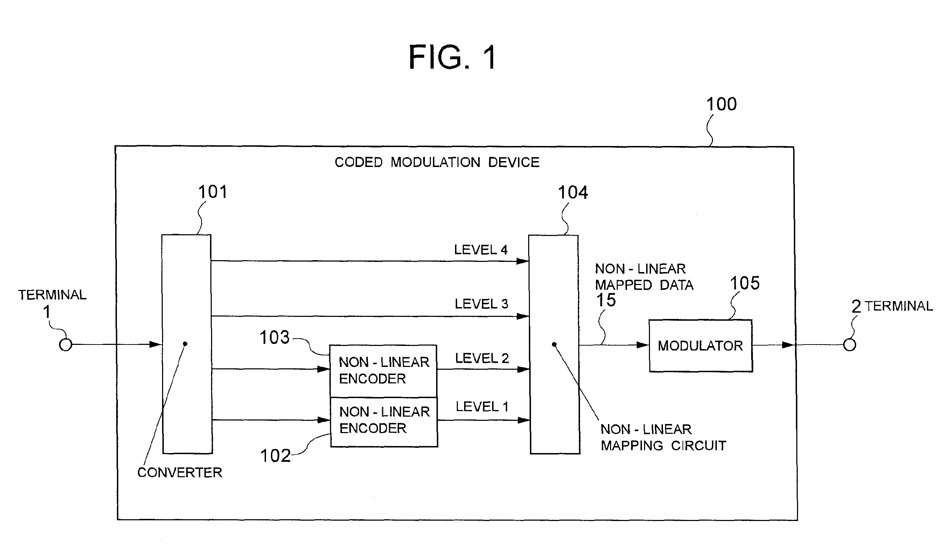

FIG. 1 is a block diagram showing a coded modulation device and method according to one embodiment of the invention.

The coded modulation device 100 comprises a converter 101, a non-linear encoder 102, a non-linear encoder 103, a non-linear mapping circuit 104, and a modulator 105, as shown in FIG. 1.

The converter 101 is a serial-parallel converter that converts one row of data inputted from a terminal 1 into plural rows of data (parallel data). The non-linear encoder 102 and the non-linear encoder 103 non-linearly encode the lower level two rows in plural rows of data converted by the converter 101, and output them as data of level 1 and data of level 2 to the non-linear mapping circuit 104. The representation of "lower level" is idiomatic, in which the levels 1 to 4 are discriminated depending on whether to encode or not.

The non-linear mapping circuit 104 maps non-linearly coded data of level 1 and level 2 and the uncoded data of level 3 and level 4 that are outputs from the converter 101 to signal points on a two-dimensional plane so that each codeword distance may be unequal interval, and outputs them as non-linearly mapped data 15.

The modulator 105 modulates a carrier wave with two-dimensional, non-linearly mapped data 15 arranged by the non-linear mapping circuit 104.

Herein, the non-linear code for use in the non-linear encoders 102, 103 is any other code than the linear codes such as convolutional code, Hamming code, BCH code, and Read Solomon code. It is the code represented in the form of a non-linear equation of simultaneousmulti-dimensional polynomials,the code represented in the form of a non-linear connection of generator polynomials, or the code not obtained by the linear operation rules.

Herein, the non-linear coding or non-linear encoder is composed of a generation circuit that is generated by the non-linear equation of simultaneous multi-dimensional polynomials, or by the non-liner connecting circuit of generator polynomials.

Also, the non-linear mapping made by the non-linear mapping circuit 104 of FIG. 1 does not arrange the signal points at the distance of equal interval between adjacent signal points on the two-dimensional plane or space, such as Phase Shift Keying (PSK) or quadrature amplitude modulation (QAM). It means such mapping that the signal points are non-linearly arranged, and the distance between adjacent signal points is not equal interval (unequal interval).

Referring to FIG. 1, the operation will be described below.

The transmission data is inputted from the terminal 1, and converted into plural rows (here four rows) by the converter 101. Among four rows of converted data, the lower two rows of data are only subjected to non-linear coding by the non-linear encoder 102 and the non-linear encoder 103. The non-linearly coded data is supplied as the data of level 1 and level 2 to the non-linear mapping circuit 104. Other data of level 3 and level 4 are not processed at all, and supplied to the non-linear mapping circuit 104.

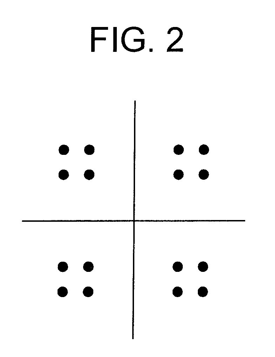

FIG. 2 is a view showing an example of mapping of the invention. This signal point arrangement is involved in the quadrature amplitude modulation, in which the transverse axis represents Ich and the longitudinal axis represents Qch.

The data of level 1 and level 2 inputted into the non-linear mapping circuit 104 and the data of level 3 and level 4 outputted from the converter 101 are non-linearly mapped onto the two-dimensional plane, as shown in FIG. 2.

Since four bits of digital signal of level 1 to level 4 are inputted into the non-linear mapping circuit 104, there are 2⁴=16 signs (as indicated by black circle) of signal points. Each signal point of black circle represents four-bit sign data from (0000) to (0101) to (1010) to (1101) to (1111).

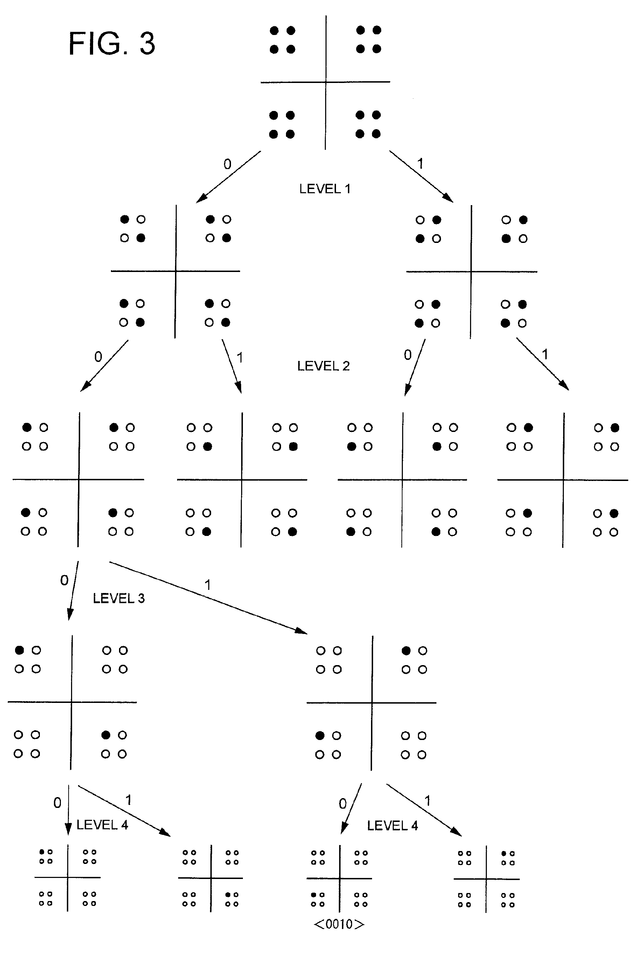

The signal point of FIG. 2 is mapped according to a signal point set partitioning as shown in FIG. 3.

FIG. 3 is a view showing one example of the signal point set partitioning operation of FIG. 2.

For example, if the digital signal of level 1 to level 4 is data of "0010", it is mapped as the third figure <0010> from the left at the level 4 by the mapping of FIG. 3.

The data of level 1 in FIG. 1 is a binary signal of "1", "0" that is non-linearly encoded by the non-linear encoder 102, in which the first set of 16 signal points in FIG. 3 is partitioned into every eight points. Furthermore, it is partitioned into sets of every four signal points by a binary signal of "1", "0" at level 2 that is non-linearly encoded by the non-linear encoder 103 of FIG. 1. Then, it is partitioned into sets of every two signal points by a binary signal of "1", "0" at level 3 in FIG. 1, and partitioned into one signal point by a binary signal of "1", "0" at level 4.

The signal point distance or sign distance between signal point sets partitioned at level 1 and level 2 is very closer than the signal point distance (sign distance) partitioned at level 3 and level 4. However, because the data at level 1 and level 2 are encoded by the non-linear coding, there is a very strong ability of identifying the signal point. That is, for identification of signal points with closer sign distance, the ability of identifying the signal point by non-linear coding is enhanced to reduce the identification error. Furthermore, the signal point set partitioned at level 3 and level 4 keeps a full signal point distance, whereby there is no danger that the signal point is mistaken.

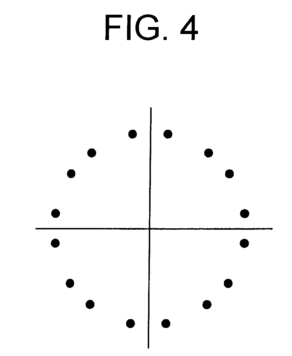

FIG. 4 is a view showing another example of mapping of the invention.

Since four bits of digital signal of level 1 to level 4 are inputted into the non-linear mapping circuit 104, there are 2⁴=16 signs (as indicated by black circle) of signal points. Each signal point of black circle indicates four-bit sign data from (0000) to (0101) to (1010) to (1101) to (1111).

A case of FIG. 4 is the non-linear mapping with a phase modulation system of PSK, in which signal points are arranged at unequal intervals on the same circumference of a circle. On the other hand, a case of FIG. 2 involves the quadrature amplitude modulation system, employing the phase and amplitude components, in which the signal points are arranged on the lattice intervals.

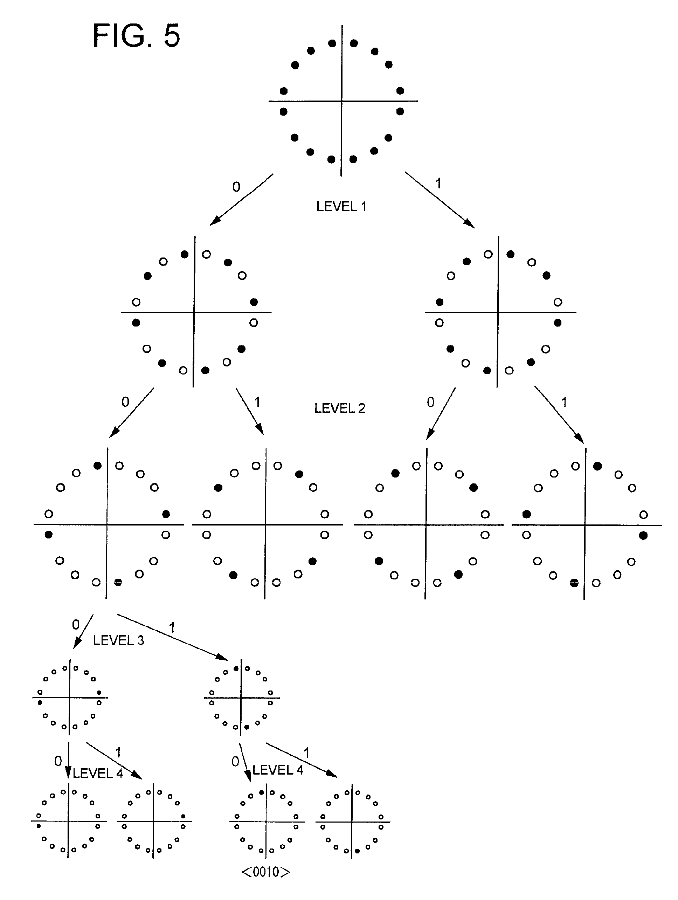

FIG. 5 is a view showing one example of the signal point set partitioning operation of FIG. 4.

For example, if the digital signal of level 1 to level 4 is data of "0010", it is mapped as the third figure <0010> from the left at level 4 by the mapping of FIG. 5.

The data of level 1 in FIG. 1 is a binary signal of "1", "0" that is non-linearly encoded by the non-linear encoder 102, in which the first set of 16 signal points in FIG. 5 is partitioned into every eight points. Furthermore, it is partitioned into sets of every four signal points by a binary signal of "1", "0" at level 2 that is non-linearly encoded by the non-linear encoder 103 of FIG. 1. Then, it is partitioned into sets of every two signal points by a binary signal of "1" , "0" at level 3 in FIG. 1, and partitioned into one signal point by a binary signal of "1", "0" at level 4.

The non-linear mapped data 15 that is non-linearly mapped on the two-dimensional plane by the non-linear mapping circuit 104 is sent to the modulator 105. The modulator 105 modulates the carrier wave with the non-linearly mapped data 15 and outputs the modulated output data from the terminal 2.

As described above, the present invention enhances the coding gain, employing the non-linear code and the non-linear mapping.

That is, one row of input data is converted into plural rows by the converter 101. The lower level data in plural rows of converted data are non-linearly encoded by the non-linear encoders 102 and 103, and outputted to the non-linear mapping circuit 104. The non-linearly coded data are mapped to signal points on the two-dimensional plane by the non-linear mapping circuit 104 so that each codeword distance may be unequal interval. The two-dimensional data arranged by the non-linear mapping circuit 104 are subjected to modulation of carrier wave by the modulator 105.

The non-linearly coded data are set in the optimal two-dimensional arrangement by the non-linear mapping, and subjected to modulation of carrier wave, so that the coding gain becomes very high. Therefore, data can be transmitted without error even in the transmission path with bad line quality such as radio path.

Owing to high degree of freedom of mapping, the invention is beneficial for the multi-value PSK system greatly affected by amplitude distortion, instead of the multi-value QAM. In addition, owing to high degree of freedom of mapping, there is an advantage that multi-value PSK mapping is made to reduce the influence of the non-linear distortion of amplitude.

## Claims

1. A coded modulation method for converting the transmission data into plural rows, non-linearly encoding a part in plural rows of converted data, andnon-linearlymappingthenon-linearly coded data to signal points having a codeword distance of unequal interval on a two-dimensional plane.

2. A coded modulation method for converting the transmission data into plural rows, and non-linearly mapping the lower level data being non-linearly coded in plural rows of converted data, and the upper level data in said plural rows of converted data to signal points having a codeword distance of unequal interval on a two-dimensional plane.

3. A coded modulation device comprising:
a data converter for converting the transmission data into plural rows;
a non-linear encoder for non-linearly encoding the lower level data in plural rows of data that are outputted from said data converter;
a non-linear mapping part for non-linearly mapping said non-linearly coded data to signal points having a codeword distance of unequal interval on a two-dimensional plane; and
a modulator for modulating a carrier wave with data mapped by said non-linear mapping part.

4. A coded modulation device comprising:
a data converter for converting the transmission data into plural rows;
a non-linear encoder for non-linearly encoding the lower level data in plural rows of data that are outputted from said data converter;
a non-linear mapping part for non-linearly mapping said non-linearly coded data and the upper level data in said plural rows of converted data to signal points having a codeword distance of unequal interval on a two-dimensional plane; and
a modulator for modulating a carrier wave with data mapped by said non-linear mapping part.

5. A coded modulation device comprising a converter, a first non-linear encoder and a second non-linear encoder, a non-linear mapping circuit, and a modulator, wherein
said converter converts one row of data that is inputted from a first terminal into plural rows of data;
said first and second non-linear encoders non-linearly encode lower level two rows of data in plural rows of data converted by said converter, and output them as data of level 1 and level 2 to said non-linear mapping circuit;
said non-linear mapping circuit non-linearly maps said data of level 1 and level 2 that are non-linearly encoded by said first and second non-linear encoders and the uncoded data of level 3 and level 4 to signal points having a codeword distance of unequal interval on a two-dimensional plane; and
said modulator modulates a carrier wave with two-dimensional data that are non-linearly mapped by said non-linear mapping circuit.

6. A coded modulation method comprising:
converting one row of data that is inputted from a first terminal into plural rows of data;
non-linearly encoding lower level two rows of data in plural rows of converted data, and outputting them as data of level 1 and level 2;
non-linearly mapping said data of level 1 and level 2 that are non-linearly encoded and the uncoded data of level 3 and level 4 to signal points having a codeword distance of unequal interval on a two-dimensional plane; and
modulating a carrier wave with two-dimensional data that are non-linearly mapped by said non-linear mapping.

7. The coding modulation method according to claim 1, wherein said non-linear coding is generated by a non-linear equation of simultaneous multi-dimensional polynomials.

8. The coding modulation method according to claim 1, wherein said non-linear coding is generated by a non-linear connection of generator polynomials.

9. The coding modulation device according to claim 3, wherein said non-linear encoder is composed of a generation circuit that is generated by a non-linear equation of simultaneous multi-dimensional polynomials.

10. The coding modulation device according to claim 3, wherein said non-linear encoder is generated by a non-linear connecting circuit of generator polynomials.
